# EUROPÄISCHE PATENTSCHRIFT

(11) **EP 0 480 135 B1**
(45) Veröffentlichungstag und Bekanntmachung des Hinweises auf die Patenterteilung: **09.11.1994**
(21) Anmeldenummer: 91112319.8
(22) Anmeldetag: 23.07.1991
(51) Int. Cl.: E06B 5/18, E06B 7/23

(54) **Kontaktaufnahmeprofil, insbesondere für geschirmte Türen mit Türrahmen für abgeschirmte Räume**
Contact profile, particularly for shielded doors with frames for shielded rooms
Profilé de contact, particulièrement pour portes blindées avec des menuiseries pour locaux blindés

(30) Priorität: 08.10.1990 DE 9014003 U
(43) Veröffentlichungstag der Anmeldung: 15.04.1992
(73) Patentinhaber: Alfred Kunz GmbH & Co., D-80336 München (DE)
(72) Erfinder: Pallor, Hans Fritz, Dipl. Ing., W-6800 Mannheim 1 (DE)
(74) Vertreter: Laufhütte, Dieter, Dr.-Ing.

(56) Entgegenhaltungen:
- EP-A- 0 304 395
- WO-A-90/02426
- BE-A- 1 001 825
- DE-A- 3 716 137
- DE-A- 3 807 833
- DE-A- 3 907 181

## Beschreibung

Die Erfindung betrifft eine Kontaktvorrichtung an einer Tür und dem zugehörigen Türrahmen für abgeschirmte Räume.

Für bestimmte Zwecke werden Räume benötigt, die gegenüber elektromagnetischen Wellen, elektrischen Pulsen und Strahlungen sicher abgeschirmt sind. Dabei soll die Abschirmung eine große Frequenzbreite mit hoher Dämpfung abdecken. Eine Abschirmung insbesondere gegenüber nieder- und hochfrequenten elektromagnetischen Wellen und elektrischen Pulsen ist beispielsweise notwenig, um Räume abhörsicher zu machen. Diese Abhörsicherheit bezieht sich nicht nur auf gesprochene Worte, sondern auch auf dem Informationsaustausch dienende Geräte. Beispielsweise besteht die Möglichkeit, die digitale Steuerung einer elektrischen Schreibmaschine abzuhören. In vielen Fällen ist es darüber hinaus erforderlich, empfindliche Geräte gegen eine diese kompromittierende Strahlung zu schützen, so daß deren unerwünschte Beeinflussung ausgeschlossen ist. Die Notwendigkeit einer Abschirmung besteht nicht nur bei Räumen, in denen sensible Informationen ausgetauscht werden, sondern auch zum Schutz empfindlicher elektrischer und elektronischer Geräte. Beispielsweise können Geräte zur Gehirnstrommessung und für kardiologische Untersuchungen und Behandlungen durch Störfrequenzen und Störpulse bis zur Funktionsunfähigkeit gestört und beeinträchtigt werden. Im militärischen Bereich und im zivilen Bereich, beispielsweise für Banken, Versicherungen und Kliniken, besteht daher ein Bedarf an geschirmten Räumen.

Während die Schirmung der Wände, Böden und Decken durch eine einwandfreie kontaktierte Schirmmetallauskleidung, beispielsweise durch Bleche der erforderlichen Permeabilität, problemlos vorgenommen werden kann, ist die Schirmung kontrollierter Durchdringungen, wie Türen und Fenster, schwierig. Besonders problematisch ist die schirmungsdichte Anordnung von Türen, da Spalte zwischen der Tür und dem Türrahmen und Einbauteile der Tür zu schirmungsundichten Leckstellen führen können. Insbesondere sind auch über die Türkonstruktion hinausragende Bauteile, beispielsweise äußere leitende Fahrrampenteile zu vermeiden, die im ungeschirmten Bereich angeordnet sind und eine gewisse Antennenwirkung zum geschirmten Teil haben können.

Bereits aus der nicht vorveröffentlichten deutschen Patentanmeldung P 39 07 181 ist es bekannt, geschirmte Türen mit Türrahmen für abgeschirmte Räume zu schaffen, die in geschlossenem Zustand schirmungsdicht in einer Raumwandung eingefügt sind. Hierzu werden einerseits das Türblatt und andererseits der Türrahmen in ihren Randbereichen umlaufend mit einem U-förmigen Profil bzw. mit einem Steg jeweils aus leitendem Material verbunden, wobei die Schenkel des U-förmigen Profils und der Steg derart gegeneinander gerichtet sind, daß sich beim Schließen der Tür der Steg in seiner Eingriffsstellung zwischen den Schenkeln des U-Profils einführen läßt. Die inneren Flanken der Schenkel des U-förmigen Profils sind dabei mit federnden Kontakten versehen, die in der Schließstellung kraftschlüssig an beiden Seiten des Stegs anliegen. Derartige federnde Kontakte weisen aber den Nachteil auf, daß sie über eine längere Gebrauchszeit funktionsuntauglich werden, da beispielsweise die Federkraft nachläßt oder da die Kontakte verbogen werden. Hierdurch kann der für eine einwandfreie Schirmung notwendige Linienkontakt an einzelnen Stellen unterbrochen sein.

Aus der BE-A-1 001 825 ist eine gattungsgemäße Vorrichtung bekannt, die zu einer Schirmung des elektromagnetischen Puls (IMP) bei atomarem Angriff dient. Es geht hier um elektromagnetische Felder nach atomaren Entladungen im Endo- und Exo-Bereich (in der Höhe bis 5 km und nicht über 5 km Höhe). Bei dieser bekannten Kontaktvorrichtung liegt ein türseitiger trapezförmiger Vorsprung mit seinen Seitenflanken an entsprechenden bauchigen Blattfedern 7 und 8 an. Zusätzlich liegt die Außenkante des im Querschnitt trapezförmigen Vorsprungs flächig an einer Dichtung an. Einen ähnlichen Aufbau weist eine Vorrichtung gemäß der WO-A-9 002 426 auf. Anstelle der blattförmigen Federn sind hier Hohlschläuche oder Rundprofile aus elastomerem Material vorgesehen.

Aufgabe der vorliegenden Erfindung ist es nun, das gattungsgemäße Kontaktaufnahmeprofil in der Weise zu verbessern, daß eine Funktionstauglichkeit auch für eine lange Gebrauchszeit gewährleistet ist.

Erfindungsgemäß wird diese Aufgabe dadurch gelöst, daß in einer Halterung ein vorgespannter gummielastisches Keder vorgesehen ist, dessen äußere Oberfläche durch ein HF-Dichtblech abgedeckt ist. Hierdurch kann der am Türblatt bzw. am Türrahmen befestigte Steg dadurch in seine Eingriffsstellung mit dem Kontaktaufnahmeprofil gehen, daß er in das HF-Dichtblech eingedrückt wird, das infolge der Eindrückkraft des Steges in den gummielastische Keder zurückgedrückt wird und aufgrund der Elastizität des gummielastischen Keders sich an die jeweilige Form des Stegs anschmiegt.

Die Halterung kann einerseits aus einem U-Profil bestehen und andererseits beispielsweise aus zwei Z-Umlaufaufnahmeprofilen.

Das HF-Dichtblech kann zweckmäßig aus Kupferberylliumblech gefertigt werden und der gummielastische Keder kann aus Moosgummi bestehen.

Weitere Einzelheiten und Vorteile der Erfindung werden anhand von in der Zeichnung dargestellten Ausführungsbeispielen erläutert. Es zeigen:
- Fig. 1:: zwei schematisch dargestellte Ausführungsformen der Erfindung im Schnitt, wobei die jeweiligen Kontakt-Aufnahmeprofile im geöffneten Zustand dargestellt sind, und
- Fig. 2:: eine der Fig. 1 entsprechende Darstellung jedoch im geschlossenen Zustand des Kontakt-Aufnahmeprofils.

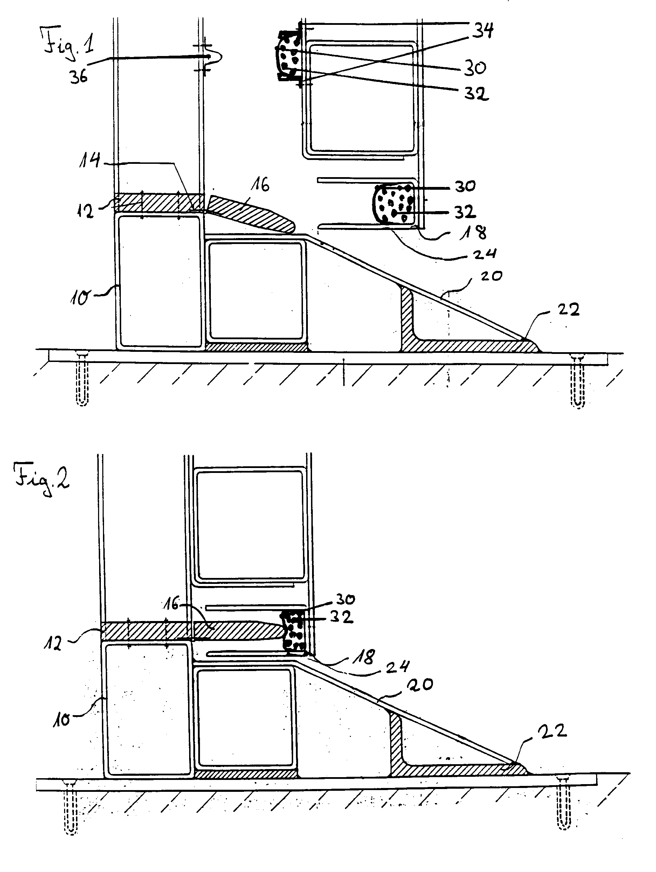

Im unteren Teil der Fig. 1 ist der Querschnitt durch eine Türschwelle und den unteren Randbereich der Tür in geöffnetem Zustand mit an die Türschwelle angelenkter Kontaktzunge 16 gezeigt. Mit der Oberseite der durch den unteren Rahmenholm des Türrahmens gebildeten Türschwelle 10 ist eine Flachleiste 12 aus schirmendem Material verbunden, beispielsweise verschweißt, an deren unteren äußeren Kanten um das Gelenk 14 schwenkbar eine Zunge 16 aus schirmendem Material angelenkt ist. Das Gelenk 14 besteht aus einem Scharnier mit abwechselnd ineinander greifenden eingerollten Ösen, durch deren fluchtende Bohrung die Scharnierachse hindurchgesteckt ist. Bei dem Ausführungsbeispiel nach dem unteren Teil der Fig. 1 ist die Unterseite der Tür mit einem U-förmigen Profil 18 verbunden, das in Richtung auf die Ebene des Türrahmens offen ist. Im Bodenbereich des U-förmigen Profils 18 ist ein vorgespannter gummielastisches Keder 32 angeordnet, welcher durch ein HF-Dichtblech 30 aus Kupferberylliumblech zur offenen Seite des U-förmigen Profils 18 hin abgedeckt ist. Dieses HF-Dichtblech ist so dünn dimensioniert, daß es leicht elastisch verformt werden kann.

Der keilförmige Teil 20 ist nach außen hin durch eine nicht leitende isolierende Trennschicht 22 getrennt.

Wie aus Fig. 1 ersichtlich ist, stützt sich im geöffneten Zustand der Tür die Zunge 16 auf der keilförmigen Rampe 20 ab, die die Höhe der Schwelle 10 ausgleicht. Wird die Tür geschlossen, greift der untere Schenkel 24 des Profils 18 an der abgerundeten äußeren Kante der Zunge 16 an, so daß diese dadurch angehoben wird und in ihre aus Fig. 2 ersichtliche klemmende Schließstellung geführt wird. In dieser Schließstellung ist der abgerundete Randbereich der Zunge 16 in das HF-Dichtblech 30 hineingedrückt, so daß sich dieses aufgrund der Elastizität des vorgespannten gummielastischen Keders 32 an den Randbereich der Zunge 16 anschmiegt. Hierdurch wird das HF-Dichtblech 30 an die Zunge 16 derart angedrückt, daß eine Unterbrechung der Gesamtkontaktfläche ausgeschlossen ist. Aufgrund des Aufbaus des Kontaktaufnahmeprofils wird deutlich, daß die Beschädigungsgefahr der Kontaktführung minimiert und die Funktionstauglichkeit über die Zeit maximiert ist.

In der oberen Schnittdarstellung der Fig. 1 ist eine Ausgestaltung des Kontakt-Aufnahmeprofils gezeigt, wie sie an den übrigen drei Seiten des Türblattes vorgesehen werden kann. Hier ist das HF-Dichtblech 30, welches den gummielastischen Keder 32 umschließt, durch zwei Z-Umlaufaufnahmeprofile 34 gehaltert. Rahmenseitig ist eine Preßmetallippe 36 vorgesehen, die beim in Fig. 1 nicht dargestellten Schließen des Türelements in das HF-Dichtblech 30 eingedrückt wird, wobei das Kontakt-Aufnahmeprofil hier durch die Preßmetallippe 36 in ähnlicher Weise verformt wird, wie es in Fig. 2 anhand der Zunge 16 dargestellt wurde.

Ein weiterer Vorteil des Kontakt-Aufnahmeprofils gem. der vorliegenden Erfindung besteht darin, daß der Übergang der Kontaktierung zwischen den in Fig. 1 im unteren Teil dargestellten befahrbaren Bodenschwellenkonstruktion der im oberen Bereich der Fig. 1 dargestellten Blattkonstruktion problemlos erhalten werden kann.

## Patentansprüche

1. Kontaktvorrichtung an einer Tür und dem zugehörigen Türrahmen für geschirmte Türen mit Türrahmen für abgeschirmte Räume mit mindestens einem am Türrahmen umlaufenden Vorsprung (36; 16) und einem an der Tür in einer Halterung (34; 18) angeordneten vorgespannten gummielastischen Keder (32), dessen äußere Oberfläche durch ein hochfrequenzdichtes Blech (30) abgedeckt ist, das so dünn dimensioniert ist, daß es elastisch verformbar ist und daß es sich beim Schließen der Tür um den nach außen vorstehenden Randbereich des Vorsprungs (36; 16) legt.

2. Kontaktvorrichtung nach Anspruch 1, dadurch gekennzeichnet, daß die Halterung aus einem U-Profil (18) besteht.

3. Kontaktvorrichtung nach Anspruch 1, dadurch gekennzeichnet, daß die Halterung aus zwei Z-Umlaufaufnahmeprofilen (34) besteht.

4. Kontaktvorrichtung nach einem der Ansprüche 1-3, dadurch gekennzeichnet, daß das hochfrequenzdichte Blech (30) aus einem Kupferberylliumblech besteht.

5. Kontaktvorrichtung nach einem der Ansprüche 1-4, dadurch gekennzeichnet, daß der Keder (32) aus Moosgummi besteht.

## Claims

1. Contact device on a door and the associated door frame for screened doors with door frames for screened rooms, having at least one projection (36; 16) which runs around the door frame, and a prestressed elastomeric beading (32) which is arranged on the door in a mounting (34; 18) and whose outer surface is covered by a radio-frequency-proof metal sheet (30) which is dimensioned to be so thin that it can be elastically deformed and wraps around the outwardly protruding edge region of the projection (36; 16) when the door is closed.

2. Contact device according to Claim 1, characterized in that the mounting consists of a U-profile (18).

3. Contact device according to Claim 1, characterized in that the mounting consists of two circumferential Z-section retaining profiles (34).

4. Contact device according to one of Claims 1-3, characterized in that the radio-frequency-proof metal sheet (30) consists of a beryllium-copper metal sheet.

5. Contact device according to one of Claims 1-4, characterized in that the beading (32) consists of rubber sponge.

## Revendications

1. Dispositif de contact sur une porte et l'encadrement de porte associé pour des portes blindées avec des encadrements de porte pour des locaux blindés, comprenant au moins une saillie (36; 16) s'étendant autour de l'encadrement de porte et un bourrelet précontraint (32) présentant une élasticité de caoutchouc disposé dans un logement (34; 18) à la porte, dont la surface externe est recouverte d'une tôle (30) étanche aux hautes fréquences qui est dimensionnée en une minceur telle qu'elle se déforme élastiquement et qu'elle s'applique lors de la fermeture de la porte autour de la zone de bord en saillie vers l'extérieur de la saillie (36; 16).

2. Dispositif de contact selon la revendication 1, caractérisé en ce que le logement est constitué d'un profil en U (18).

3. Dispositif de contact selon la revendication 1, caractérisé en ce que le logement est constitué de deux profilés récepteurs en forme de Z s'étendant tout autour (34).

4. Dispositif de contact selon l'une des revendications 1 à 3, caractérisé en ce que la tôle étanche aux hautes fréquences (30) est constituée d'une tôle de cuivre-béryllium.

5. Dispositif de contact selon l'une des revendications 1 à 4, caractérisé en ce que le bourrelet (32) est réalisé en un caoutchouc spongieux.
